# EUROPEAN PATENT APPLICATION

(11) **EP 3 903 948 A1**
(43) Date of publication of application: **03.11.2021**
(21) Application number: 20172246.9
(22) Date of filing: 30.04.2020
(51) Int. Cl.: B05D 5/06, B05D 7/04, B05D 7/00, C23C 14/00, C23C 14/20

(54) **A METALLIZED LAMINATE AND A METHOD FOR FORMING AND ADJUSTABLY COLORING A METALLIZED LAMINATE**

(71) Applicant: Plastal Industri AB, 412 63 Göteborg (SE)
(72) Inventor: Kerlin Jr, Eliot, Dallas, Texas 75220 (US); Wiskel, David, Windsor, Ontario N8N 5H4 (CA); Berezowski, Tim, Niagara Falls, Ontario L2H 2Z3 (CA)
(74) Representative: AWA Sweden AB

(57) **Abstract**

A method for forming and adjustably coloring a metallized laminate, comprising: providing a polymeric substrate, applying a first coating, wherein said coating comprises a thermally curable polymeric substance, thermally curing said first coating for a first time duration, determining a desired colouring of the provided metal laminated substrate, applying a metal layer by means of physical vapor phase deposition, said metal layer having a first average thickness on a first portion of said substrate corresponding to said desired colouring, applying a second coating, wherein said coating comprises thermally curable polymeric substance, thermally curing said second coating for a second time duration.

## Description

### Field of the invention

The invention relates to a method for forming and adjustably coloring a metallized laminate, and a metalized laminate thereof.

### Background

Metalized polymeric finishes are often used to complement or even replace conventional reflective surfaces such as chrome plated surfaces, in various industrial areas. These structures are widely used in the automobile industry, as in addition to their lighter weight, and resulting better fuel economy, they are less expensive and time consuming to manufacture in comparison to the conventional chrome plating techniques. Depending on the desired final appearance of the product, it is necessary that these structures can be manufactured in a variety of different metallic colors or finishes.

Metalized polymeric substrates have been disclosed previously, wherein a metallic layer is deposited using common deposition techniques, sandwiched between two coating layers applied to the substrate before and after the metallization. The first layer typically serves the purpose of surface smoothening and enhancing the adhesion of the metallic layer to the polymeric substrate, while the top layer acts as a protective layer against micro scratching, chemical reactions of the metallic layer and the ambient atmosphere, while at the meantime providing a high-gloss or matt finish to the structure. These layers are typically in need of curing or hardening before the deposition of the next consecutive layer. By UV curing, the polymer chains in the material are cross-linked, leading to the desired hardening of the sandwiching layers. A drawback of this method is that an enhanced cross linking may lead to material brittleness due to shrinkage during polymerization, or, due to the difference in thermal expansion coefficients of the metallic layer and the coating layers.

US9994952B2 discloses a method of overcoming the above-mentioned problem. In this document, a first layer (basecoat) applied onto the polymeric substrate prior to deposition of a metallic layer through means of Physical vapor deposition (PVD). A high-gloss UV curable topcoat is applied as the finishing layer, covering the PVD layer. In order to tackle the undesired effects, in addition to a mercury lamp, which is used for curing the top (and possibly) bottom coatings throughout the entire depth, a second UV source with a narrow spectrum width is utilized. The wavelength of the second source is specifically chosen such that it will only penetrate the coating layer only a small depth, causing further polymerization of only the surface of the layer. However, the latter-mentioned method not only requires multiple UV sources, which increase the cost significantly, apart from mentioning a matte-glossy finish, does not solve the technical problem of providing a custom-designed color and/or finish of the final product.

EP3539679A1 discloses an aging resistance coating film for a hub, sequentially comprising an Aluminium alloy matrix, a silane conversion film, a high-gloss organic resin coating, a periodic variable alloy black chromium coating film and a transparent resin coating. The alloy black chromium coating film can produce a black and bright metal color. The periodic variable alloy black chromium coating film is a C-Cr periodic variable alloy black chromium coating film obtained by means of PVD, from a high-purity C target and a high-purity Cr target by setting different coating processes. 90%-0 of C component changes periodically, 10-100% of Cr metal component changes periodically, the two materials change periodically in accordance with the above alloy composition to achieve a black metal color, and the power of the C target is adjusted to form different coating film components and obtain a black chromium alloy coating film with different blackness.

Even though this document discloses a method for achieving different colors between metallic black and chrome, there is a need for a less environmentally hazardous method.

### Summary of the invention

An object of the invention is to provide a device/method that has less environmental impact, meanwhile being cost efficient. The invention is based on the inventors' realization that instead of, as in the prior art, using the environmentally hazardous material Chrome in combination with Carbon which is also an expensive and complicated process, forming of the metallized laminate may be achieved by depositing an intermediate metal layer my means of physical vapor deposition, sandwiched in between two thermally cured coatings. By this, a method with less environmental impact is provided.

According to a first aspect of the invention, the object is achieved by a method for forming and adjustably coloring a metallized laminate, comprising: providing a polymeric substrate, applying a first coating, wherein the first coating comprises a thermally curable polymeric substance, thermally curing the first coating for a first time duration, determining a desired colouring of the provided metal laminated substrate, applying a metal layer by means of physical vapor phase deposition, the metal layer having a first average thickness on a first portion of the substrate corresponding to the desired colouring, applying a second coating, wherein the second coating comprises thermally curable polymeric substance, thermally curing the second coating for a second time duration.
By this method a metalized laminate may be achieved by which the main problem raised in the background, namely environmental hazards may be alleviated, and the final coloring and appearance may be adjusted to desire. It is noted that, by the term adjustably coloring it is meant that the final color/appearance of the laminate is determined, and the method parameters, i.e. thickness of metallic layer is adjusted accordingly.

The polymeric substrate may be of any material such as but not limited to a pure PC or PP or a blend such as, PC-ABS, PC-ASA, PC-PET, PC-PBT, TPO or any other paintable plastic material.

An advantage of using a polymeric substrate may be improved flexibility and better elastic bending coefficients. This may be beneficial in reducing the number of wasted pieces that may get damaged due to inflexibility during assembly.

According to an embodiment of the method, the temperature for the thermal curing falls between 50 and 110 °C, preferably between 75 to 105 °C, most preferably between 80 to 100 °C.

According to an embodiment of the method, the first, and second time durations are longer than 30 minutes, preferably longer than one hour, most preferably longer than 2 hours.

The first and second coatings may or may not be the same substance. In the case that they are the same, they may be cured with the same process parameters, i.e. same temperature, and duration. Alternatively, they may be cured under different process parameters.

The thickness of the first and second coatings may be equal. In this case, the process parameters, e.g. curing time and temperature of the first and second coatings may or may not be equal.

Alternatively, the thickness of the first and second coatings may be different. In this case, the process parameters, e.g. curing time and temperature may be different for each of the first and second coatings. Alternatively, the process parameters may be chosen to be the same.

Coating thickness, curing time and temperature may be dependent on the comprising material of the first and second coatings, on the desired final properties, and the level of desired hardening of each of the coatings.

According to one embodiment of the method, a substrate color of the polymeric substrate is determined according to the desired coloring of the metallized laminate.

The final appearance of the metalized laminate may be dependent on a number of factors, and may refer to a number of aesthetic factors, for instance it may refer to the color of the metalized laminate which may vary between metallic black, to silver, to chrome. The final color of the metalized laminate may depend on the initial color and/or light transparency of the polymeric substrate. Alternatively, or additionally, the final color may largely depend on the average thickness of the deposited metal on the substrate. For instance, but not limited to, for a dark or black initial coloring of the polymeric substrate, at low average thicknesses of he deposited metallic layer, may result in a metallic black coloring. In the same manner, for medium average thicknesses of the metallic layer, the final color may be resemble a silver-like coloring. Alternatively, for a high average thickness of the metallic layer, the color of the finalized laminate may resemble that of chrome. This may be linked to the absorbance/reflectance of incident light at the metalized laminate/air interface, which in turn may be depended on the surface thicknesses of the comprising layers. Alternatively, or additionally, the coloring of the finalized laminate may depend on the final tint of the post - cured second coating layer.

Alternatively, or additionally, according to another embodiment of the method, an additional step of spray-painting a paint layer before applying said second coating is carried out. By this a metalized laminate with a metallic finish with any desired color, for instance but not limited to, blue, may be achieved. It may be that the excessive liquid of the spayed paint needs to be removed, and the paint layer hardened prior to applying the second coating.

Alternatively, or additionally, according to yet another embodiment of the method, additional steps of adjusting a surface roughness of the polymeric substrate is carried out before step b, such that the surface roughness contributes to a final appearance of the metalized laminate.
the final appearance may be used to refer to the brushing of the final metalized laminate. For that purpose, the surface roughness of the polymeric substrate may be determined and adjusted prior to the laminating process. For a brushed Aluminium-like final appearance, the surface of the polymeric substrate may be roughened. This roughening may be accomplished by methods such as, but not limited to graining of the substrate tooling or mechanical or chemical removal of material of the actual substrate. It is noted that, for achieving the blushed appearance, the thickness of the first coating layer may need to be adjusted such that post-curing of the first coating layer, the surface roughness of the substrate may be maintained.

According to one embodiment of the method, the first coating composition is a solvent born spray and the second coating composition is a solvent born spray.

The first coating composition and the second coating compositions may be sprayed onto the substrate using for instance, but not limited to a spray gun.

According to one embodiment of the method, additional steps of flash-off is carried out before steps c, and f, so to remove at least 90%, preferably at least 95%, most preferably at least 97% of the solvent liquid.

By this the excessive liquid may be removed from the first and second coating compositions post spray, and prior to the curing steps, so to further optimize the process.

According to an embodiment of the method, the metal is Indium or an alloy thereof.

By using a layer of Indium or an Indium-based alloy for metalizing the laminate, the environmental hazards associated with Chrome may be alleviated, as Indium may be regarded as an environmentally benign element. Meanwhile Indium offers color, bright shine and gloss similar to those of chrome and the necessary adhesion and anti-corrosion properties.

According to and embodiment of the method, the Indium or the alloy thereof layer comprises islands of Indium or islands of the alloy thereof.

The average thickness of the deposited metal preferably may not be sufficient to result in a continuous atomic layer on the substrate surface. Thus, discontinuous islands of Indium or the alloy there of will form on the substrate surface. This is due to the surprising realization of the inventors that, in order to achieve a metallic finish, it may be advantageous to limit the average thickness of the deposited metal layer below what would result in the formation of a continuous layer. Otherwise, it may be that the final appearance of the laminate be a dull metallic look. This may not be the desired final look, unless preferred otherwise. In the case that a dull metallic finish is desired, enough metal may be deposited by physical vapor deposition, so to allow the formation of a continuous metallic layer on the surface of the substrate, such that full coverage is achieved.

According to one embodiment of the method the islands comprise different surface areas and/or thicknesses.

For a given average thickness, the islands may have different surface areas, and/or atomic layer thicknesses depending on the in-situ microscopic conditions during physical vapor phase deposition of the metallic layer. If these island parameters vary from one portion of the substrate to another, it may result in portions with different final optical appearances of the substrate.

According to one embodiment of the method the metallic layer comprises a second average thickness on a second portion of the substrate, such that the first average thickness and the second average thickness are not equal.

It may be that, different portions of the same substrate are subjected to different amounts of metallic material deposition, in order to attain different average thicknesses of the metallic layer at different portions. Thus, by utilizing this technique, a metalized laminated substrate comprising portions with different metallic colorings may be achievable.

Alternatively, it may be that the average amount of deposited metallic material is gradually varied in a certain direction or radii, such that a gradient look of metallic coloring is achieved.

According to one embodiment of the method the first average thickness corresponds to a first end of a color gradient, while the second average thickness corresponds to a second end of a color gradient.

In a specific case of having two metallization sources positioned over different portions of the substrate such that each source is configured to deposit a different nominal average thickness on the substrate, each portion of the substrate exposed to the first, or second average deposition thickness may have a coloring according to that deposition thickness. The area on the substrate in between may have an average thickness falling in between the first and second average thicknesses, hence consequently a coloring lying in between the first and second color. Depending on the positioning of the sources in relation to the substrate, and to one another, a gradient in thickness, thus coloring may occur.

It is necessary to be noted that, the sources need not to be limited to two, but may be three, four or even more depending on the requirements.

It is also noted that, in the case where there is more than two sources the average deposition thickness corresponding to each source may vary in a linear ascending or descending manner over the length and/or width of the substrate. This may give rise to a linear coloring thickness over the area of the substrate. Alternatively, the sources may be positioned in relation to the substrate and each other, so to provide for a radial gradient. Alternatively, or additionally, the average thickness of the consecutive sources need not be ascending or descending in a linear manner. This may give a "wave-like" coloring appearance to the metalized substrate.

According to a second aspect of the invention, a metallized laminate obtainable by the method according to the first aspect of the invention is provided.

According to another aspect of the invention, a part, preferably an automotive part, comprising a metallized laminate according the second aspect of the invention is provided.

The automotive part may be any part of the exterior of an automotive part, such as but not limited to reflex frames of automotive lamps, and bumpers, decor elements like emblems, door handles, air deflectors and trim lists. Additionally, or alternatively, the automotive part may be an interior component, such as but not limited to trim parts, knobs, emblems, door handles, covers and other design elements

As these components may be more flexible and bendable, utilizing such components as exterior automotive parts may be beneficial in reducing pedestrian damage occurring in case of driving accidents. Additionally, it may give rise to better resistance against stone chipping, and/or corrosion.

According to yet another aspect of the invention, the use of a metallized laminate according to the second aspect of the invention in an automotive part is provided.

### Brief description of drawings

Further details and aspect of the present invention will become apparent from the following detailed description with reference to accompanying drawings, in which
Fig. 1 demonstrates a flow chart for forming and adjustably coloring a metalized laminate.
Fig. 2. Depicts a cross sectional view of the final metalized laminate.
Fig. 3 depicts a perspective top view of the metalized laminate at an intermediate step.
Fig. 4 depicts a perspective side view of the final metalized laminate.
Fig. 5 shows a cross sectional view of the final metalized laminate.
Fig. 6 depicts an automotive component metalized by the method according to the first aspect of the invention.

### Detailed description of drawings

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and fully convey the scope of the invention to the skilled addressee. Like reference characters refer to like elements throughout the application.

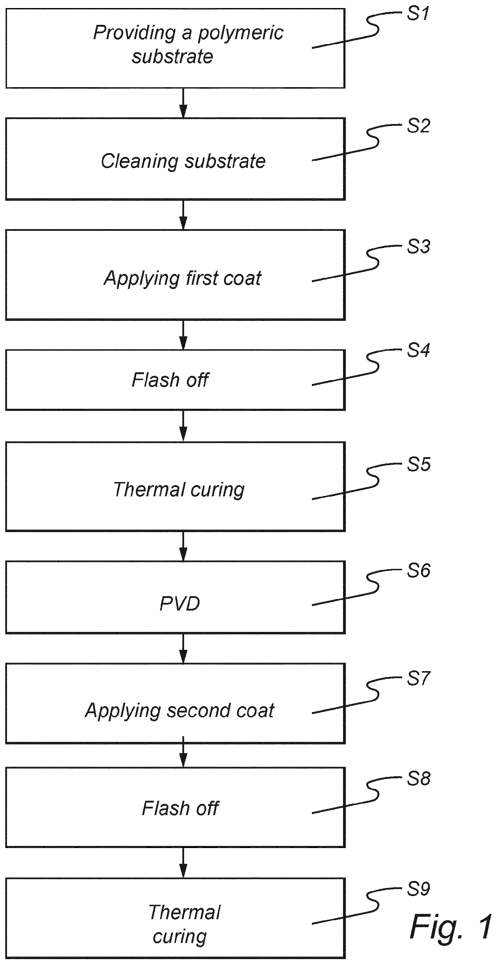

Figure 1 depicts a flow chart according to one embodiment of the method of forming a metallized laminate. In step S1, a polymeric substrate 110 is provided. The polymeric substrate 110 is moulded into the desired shape by methods such as, but not limited to injection moulding. The polymeric substrate 110 can comprise of material such as a PCS blend, PP, pure PC, or any other paintable plastic material. In step S2, the polymeric substrate 110 is cleaned by, for example, power washing, or CO₂, or alternatively by a deionized air flow. Next, in step S3 of the flow chart the first coating layer 120 is applied to the substrate 110. The next step S4 of the flow chart of Fig. 1, flash-off is carried out in order to remove at least 90%, preferably at least 95%, most preferably at least 97% of the solvent liquid of the first coating 120. Note that this step may be considered optional, hence not carried out if desired. Step S5 of the flow chart the first coating layer 120 is thermally cured. Note that thermal curing may be carried out by convection, or alternatively by Infrared radiation. In the later stage S6 of Fig. 1 the substrate is metallized by Physical vapor deposition methods, such as, but not limited to thermal evaporation. The In layer 130, 135 is deposited on the surface 125 of the first coating layer 120 in through this step. Note that in the context of this invention unless stated otherwise by "In layer" it is meant to refer to the discreet In islands deposited on the surface 125 of the first coating layer 120. In the step of the flow chart S6, the metalized substrate is coated by the second coating layer 140. Again, an optional flash off step is depicted in S8 of the flow chart, which may remove at least 90%, preferably at least 95%, most preferably at least 97% of the solvent liquid of the second coating layer 140. In the final step S8 of the flow chart, the second coating layer 140 is thermally cured.

It may be that the first coating 120 and the second coating 140 layer is comprised of the same material. This material may comprise a hardener, an additive, which acts as an adhesion promoter, and a thinner.

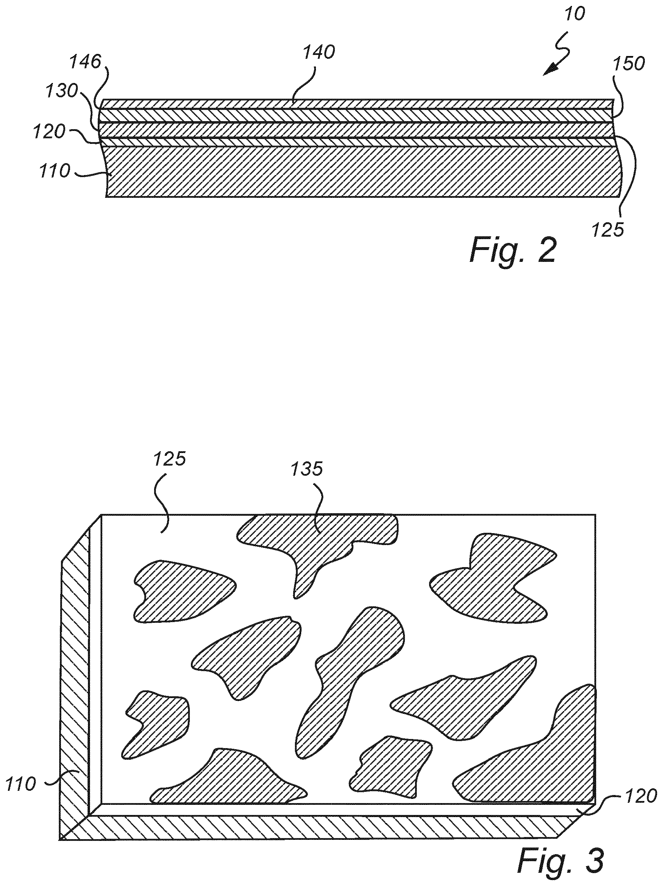

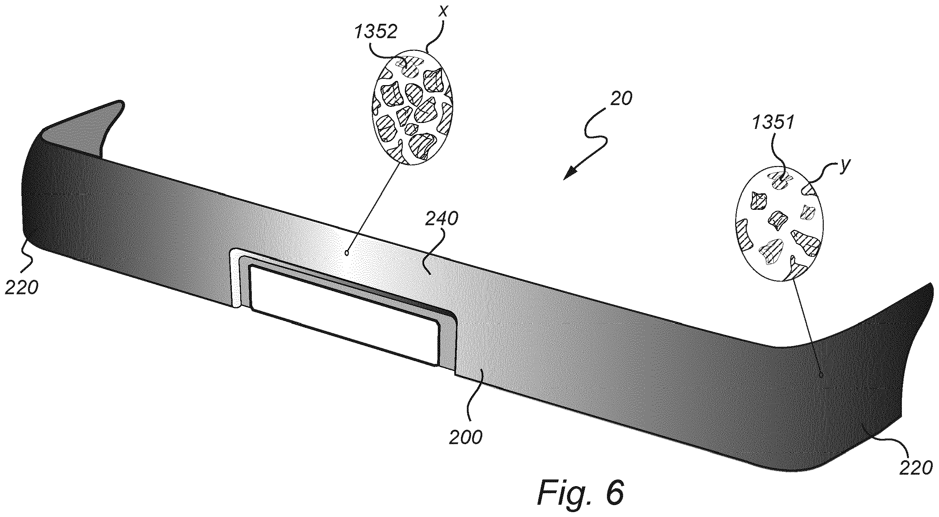

Figure 2 schematically demonstrates a cross section of the final metal laminated substrate 10. The polymeric substrate 110 is coated by the first coating layer 120. The metallic In layer 130 is sandwiched between the first coating 120 and the second coating 140. Note that the illustration in figure 2 is a conceptual demonstration, and the In layer 130 may be continuous as shown in figure 2, or a collection of In Islands 135 as shown in the embodiments of figures 3-6. In the embodiment of figure 3 a paint layer 150 is shown situated under the second coating 140. The paint layer 150 may be applied prior to the application of the second coating layer 140 during the manufacturing method, so to have a metallic laminate in any desired color other than chrome-like metallic to metallic black, such as but not limited to metallic red, or metallic green. Note that, the final color may appear brighter when the paint layer 150 is applied over a denser In Island layer 1352 compared to when applied over a relatively sparse In island layer 1351 (see figure 6).

Figure 3 depicts a perspective top view of the laminated substrate 10 according to the method of claim 1 after the intermediate step of depositing the In island layer 135 through PVD. As seen in the figure the In islands are discreetly deposited on the surface 125 of the first coating layer 120. The average size of the In islands 135 is dependent upon the amount of material deposition by PVD, and ultimately determines the final appearance of the metalized laminate 10. If the In islands 135 have a relatively high density (more material) the laminate 10 will have a chrome-like metal appearance due to more light being reflected off the surface of the In islands 135. Alternatively, if the In islands 135 have a relatively lower density (less material), a bigger portion of the surface 125 of the first coating layer 120 will be exposed, hence due to more light being absorbed by the larger exposed surface 125 than light reflected by the In islands 135, the final laminate 10 will have a black metallic appearance. The average thickness of the In islands may preferably be in the range of 0.05-10 µm.

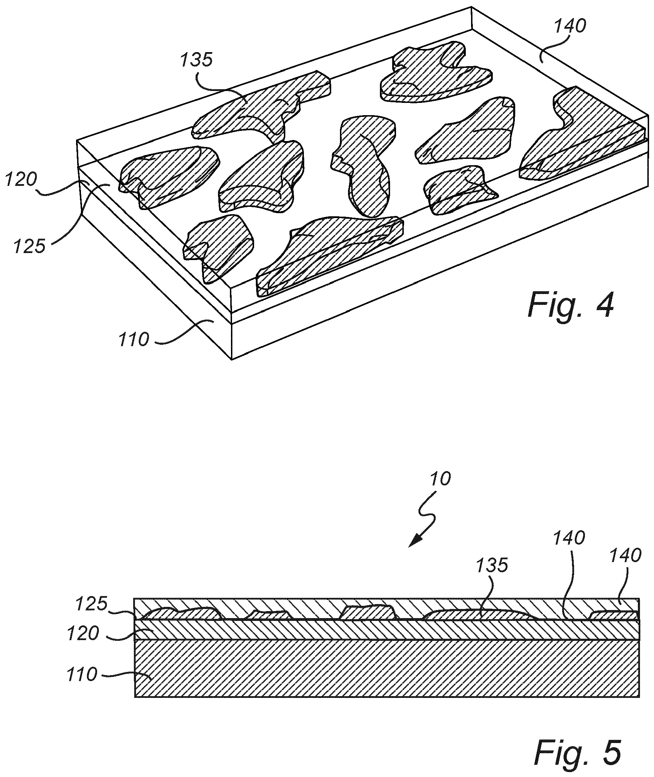

Figure 4 depicts a perspective side view of the final metalized laminate 10 manufactured according to the first aspect of the method. The polymeric substrate 100, covered by the first coating layer 120, the In islands 135 and the second coating layer 140 are visible. The In islands 135 are positioned on the surface 125 of the first coating layer 120, leaving portions of the surface 125 exposed to the bottom surface 146 of the second coating layer 140.

In the side view given in figure 5, the proximity of the surface 125 of the first coating layer 120 and the bottom surface 146 of the second coating layer 140 can be seen more clearly. This allows for mechanical bonding of the first 120 and second 140 coating layers, which will ultimately result in further improving the mechanical properties of the final metalized laminate 10.

Figure 6 shows an example embodiment of the laminating method used in metalizing an automotive part, specifically a vehicle bumper 20. A gradient color appearance of the bumper 20 is visible; going from metalized black 220 on one end to chrome-like appearance 240 is the middle, and back to metalized black 220 on the other end. As shown by the magnified views of X and Y, these different appearances are linked to the In island density: the bright metalized appearance 240 is due to a higher In island density 1352 as shown in view X, while a black metalized appearance 220 is due to a lower density of In islands 1351 as shown in view Y.

The person skilled in the art realizes that the present invention by no means is limited to the preferred embodiments described above. On the contrary, many modifications and variations are possible within the scope of the appended claims. Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. A method for forming and adjustably coloring a metallized laminate, comprising:
a) providing a polymeric substrate,
b) applying a first coating, wherein said coating comprises a thermally curable polymeric substance,
c) thermally curing said first coating for a first time duration,
d) determining a desired colouring of the provided metal laminated substrate,
e) applying a metal layer by means of physical vapor phase deposition, said metal layer having a first average thickness on a first portion of said substrate corresponding to said desired colouring,
f) applying a second coating, wherein said coating comprises thermally curable polymeric substance,
g) thermally curing said second coating for a second time duration.

2. The method according to claim 1, wherein said first coating composition is a solvent born spray and wherein said second coating composition is a solvent born spray.

3. The method according to claim 2, wherein additional steps of flash-off is carried out before steps c, and f, so to remove at least 90%, preferably at least 95%, most preferably at least 97% of the solvent liquid.

4. The method according to claim 1 wherein said metal is Indium or an alloy thereof.

5. The method according to claim 4, wherein said Indium or an alloy thereof layer comprises islands of Indium or islands of an alloy thereof.

6. The method according to claim 5, wherein said islands comprise different surface areas and/or thicknesses.

7. The method according to any of the preceding claims, wherein the metallic layer comprises a second average thickness on a second portion of said substrate, such that said first average thickness and said second average thickness are not equal.

8. The method according to claim 7, wherein said first average thickness corresponds to a first end of a color gradient, while said second average thickness corresponds to a second end of a color gradient.

9. The method according to any of the preceding claims, wherein the temperature for the thermal curing falls between 50 and 110 °C, preferably between 75 to 105 °C, most preferably between 80 to 100 °C.

10. The method according to any of the preceding claims, wherein the first, and second time durations are longer than 30 minutes, preferably longer than one hour, most preferably longer than 2 hours.

11. The method according to any of the preceding claims, wherein a substrate color of said polymeric substrate is determined according to said desired coloring of the metallized laminate.

12. The method according to any of the preceding claims, wherein an additional step of spray-painting a paint layer before applying said second coating is carried out, followed by a flash-off step for removing the liquid in the paint layer

13. The method according to any of the preceding claims, wherein additional steps of adjusting a surface roughness of the polymeric substrate is carried out before step b, such that said surface roughness contributes to a final appearance of said metalized laminate.

14. A metallized laminate obtainable by the method according to any one of claims 1 -13.

15. A part, preferably an automotive part, comprising a metallized laminate according to claim 14.

16. Use of a metallized laminate according to claim 14 in an automotive part.
